# EUROPEAN PATENT SPECIFICATION

(11) **EP 1 412 550 B1**
(45) Date of publication and mention of the grant of the patent: **25.03.2009**
(21) Application number: 02755628.1
(22) Date of filing: 16.07.2002
(51) Int. Cl.: C23C 14/04, C23C 16/04, H01L 23/26, C23C 14/08, C23C 16/40

(54) **SUPPORT WITH GETTER-MATERIAL FOR MICROMECHANICAL DEVICE**
TRÄGER MIT GETTER-MATERIAL FÜR EIN MIKROMECHANISCHES BAUELEMENT
SUPPORT POUR DISPOSITIFS MICROMECANIQUES

(30) Priority: 20.07.2001 IT MI20011558; 03.04.2002 IT MI20020068
(43) Date of publication of application: 28.04.2004
(73) Proprietor: SAES GETTERS S.p.A., 20020 Lainate (Milano) (IT)
(72) Inventor: AMIOTTI, Marco, I-27029 Vigevano (IT)
(74) Representative: Adorno, Silvano
(86) International application number: PCT/IT2002/000466
(87) International publication number: WO 2003/009318

(56) References cited:
- EP-A- 0 837 502
- WO-A-00/61832
- US-A- 3 214 381
- US-A- 4 630 095
- US-A- 5 520 563
- US-A- 5 656 889
- US-A- 5 882 727
- US-A- 5 921 461

## Description

The present invention relates to a support for manufacturing microelectronic, microoptoelectronic or micromechanical devices with integrated deposit of gas absorbing material.

Microelectronic devices (also called integrated electronic circuits, indicated in the field with the abbreviation ICs) are the base of the whole integrated electronic industry. Microoptoelectronic devices comprise, for example, new generation infrared radiation (IR) sensors which, unlike traditional ones, do not require cryogenic temperatures for their operation. These IR sensors are formed of an array of semiconductor material deposits, for example silicon, arranged in an evacuated chamber. Micromechanical devices (better known in the field as "micromachines" or its abbreviation MMs) are in developing step for applications such as miniaturized sensors or actuators: typical examples of micromachines are microaccelerometers, used as sensors to activate automobile airbags; micromotors, having gears and sprocket wheels of the size of a few microns, or optic switches, wherein a mirror surface with a size of the order of a few tens microns (µm) can be moved between two different positions, directing a light beam toward two different directions, one corresponding to the "on" condition and the other to the "off' condition of an optical circuit. In the following, all these devices will also be referred to with the general definition of solid state devices.

ICs are manufactured by a technology comprising operations of deposit on a planar support of layers of material with different electric (or magnetic) functionality, alternated to selective removals thereof. The same techniques of depositions and selective removals are applied to microoptoelectronic or micromechanical devices construction as well. These are generally contained in housings formed, in their turn, with the same techniques. The support most commonly used in these productions is a silicon "slice" (said "wafer" in the field), about 1 mm thick and with a diameter up to 30 cm. On each of these wafers a very high number of devices is constructed; then, at the end of the manufacturing process, from these slices are separated, by mechanical or laser cut, the single devices in the case of micromachines, or parts including an array of some tens of devices in the IR sensors case.

The deposition steps are carried out with such techniques as chemical deposition from vapor state, generally defined "CVD" from the English "Chemical Vapor Deposition", or physical deposition from vapor state or "PVD", from the English "Physical Vapor Deposition", the latter commonly indicated also with the English name "sputtering". Generally, selective removals are carried out through chemical or physical attacks with proper masking, as it is well known in the field.

The integrated circuits and the micromachines are then encapsulated in polymeric, metallic or ceramic materials, essentially for mechanical protection reasons, before being inserted in the final destination apparatus (a computer, an automobile, etc.). On the contrary, IR radiation sensors are generally comprised in a chamber, facing one wall thereof defined as "window", transparent to the IR radiation.

In some kinds of integrated circuits it is important to be able to control the gas diffusion in solid state devices: it is for example the case of ferroelectric memories, wherein hydrogen, diffusing through device layers, can reach the ferroelectric material (generally a ceramic oxide, such as lead titanate-zirconate, strontium-bismuth tantalate or titanate, or bismuth-lanthanum titanate), altering its correct behavior.

Still more important is gas control and elimination in IR sensors and in micromachines. In the case of IR sensors, the gases possibly present in the chamber can either sorb part of the radiation or transport heat by convection from the window to the array of silicon deposits, modifying the measure. In micromachines, the mechanical friction between gas molecules and the moving part, due to the very small size of the latter, can lead to sensible deviations from the device's ideal operation; moreover, polar molecules such as water can cause phenomena of adhesion between the moving part and other parts, for example the support thereof, thus causing the device's failure. In the IR sensors with arrays of silicon deposits or in the micromachines, it is therefore fundamental to be capable of ensuring the housing to remain in vacuum for the whole device life.

In order to minimize the gas amount in these devices, their production is usually conducted in vacuum chambers and resorting to pumping steps before the packaging thereof. Anyway the problem is not completely solved in this way, because the same materials which form the devices can release gases, or these can permeate from outside during the device life.

To remove also the gases entering in solid state devices during their life, it has been proposed to use materials that can absorb them. These materials comprise those commonly referred to as "getters, generally metals such as zirconium, titanium, vanadium, niobium or tantalum, or alloys thereof with other transition metals, with rare-earth elements or aluminum, having a very strong chemical affinity towards gases such as hydrogen, oxygen, water, carbon oxides and in some cases nitrogen; and drier materials, specific for moisture sorption, among which mainly the oxides of alkali or alkaline-earth metals. The use of materials for absorbing gases, particularly hydrogen, in ICs, is described for instance in patent US-A-5,760,433 and in published Japanese patent applications JP-11-040761 and JP-2000-40799; their use in IR sensors is described for example in patent US 5,921,461; finally, the use of gas absorbing materials in micromachines is described for example in the article "Vacuum packaging for microsensors by glass-silicon anodic bonding" by H. Henmi et al., published on technical journal Sensors and Actuators A, vol. 43 (1994), at pages 243-248.

Localized deposits of gas absorbing materials can be obtained by CVD or sputtering during solid state devices productive steps. However, this procedure is not very appreciated by manufacturers of these devices, since the deposition of the absorbing material during devices production implies the need that the total process is added with a step of localized deposition of this material, generally carried out through the operations of resin deposition, resin local sensitization through radiations (generally UV), selective removal of the photosensitized resin, gas absorbing material deposition and subsequent removal of the resin and of the gas absorbing material thereon deposed, leaving the gas absorption material deposit in the area from which the photosensitized resin had been removed. Moreover, the deposit of the gas absorbing material in the production line has the disadvantage that increasing the number of different steps of the process and of the materials therein used, also the risk of "cross-pollution" among the different chambers in which said different steps are carried out increases, with following possible increase of waste products because of contamination.

The object of the present invention is to overcome the above-described problems of the prior art and, particularly, to simplify the manufacturing of solid state devices.

This object is achieved according to the present invention with a support for manufacturing microelectronic, microoptoelectronic or micromechanical devices, the main characteristics of which are specified in claim 1 and other characteristics of which are specified in the following claims.

The support of the invention is practically similar to silicon wafers commonly used in industry having, however, a gas absorption material (in'the form of discrete deposits) deposited in hollings onto the surface on which the microelectronic or micromechanical devices are constructed.

The invention will be described below with reference to the drawings in which:
- Fig. 1 shows in perspective, partially in section, a support;
- Fig. 2 shows a sectional view of the support in Fig. 1;
- Figs 3-5 represent operative phases for constructing a solid state device starting from the support of Fig. 1;
- Fig. 6 shows in perspective, partially in section, a support according to the invention;
- Fig. 7 shows a sectional view of support in Fig. 6;
- Fig. 8 represent a solid state device obtainable from support of Fig. 6; and
- Fig. 9 shows a sectional view of a solid state device constructed starting from the support of Fig. 6.

For the sake of description clarity, in the drawings height-diameter ratio of supports of the invention and lateral dimensions of gas absorbing material deposits upon the base are exaggerated with respect to real dimensions. Moreover, in the drawings, supports are always represented with a wafer geometry, that is a low disk of material, because this is the geometry commonly adopted by the producers of solid state devices, but this geometry could be also different, for example square or rectangular.

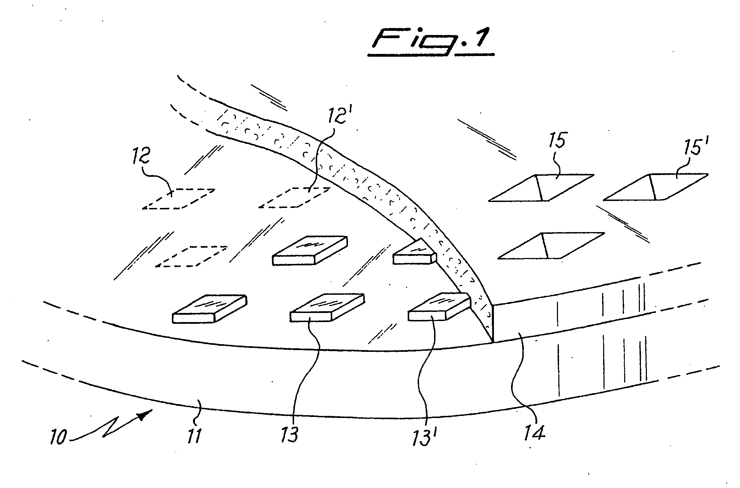

In figure 1 is shown a partial sectional view of a support 10. Said support, 10, comprises a base, 11, having the only function of backing the support and devices deriving therefrom, and constitutes nearly the whole thickness of support 10 (within the range of millimeters). Base material can be a metal, a ceramic, a glass or a semiconductor, preferably silicon.

In areas 12, 12', ..., of the surface of base 11, discrete deposits 13, 13', ... of a gas absorbing material are obtained. Then these deposits are covered with a layer 14 of a material compatible with ICs or MMs production process. This layer 14 performs duty of anchorage for layers subsequently deposed thereon to construct ICs, microoptoelectronic devices or MMs, or it can be even itself the layer in which these devices are constructed (for example micromachines moving parts can be obtained in this layer by removing parts thereof). Moreover the final device's soldering can be possibly made directly on the edge of layer 14.

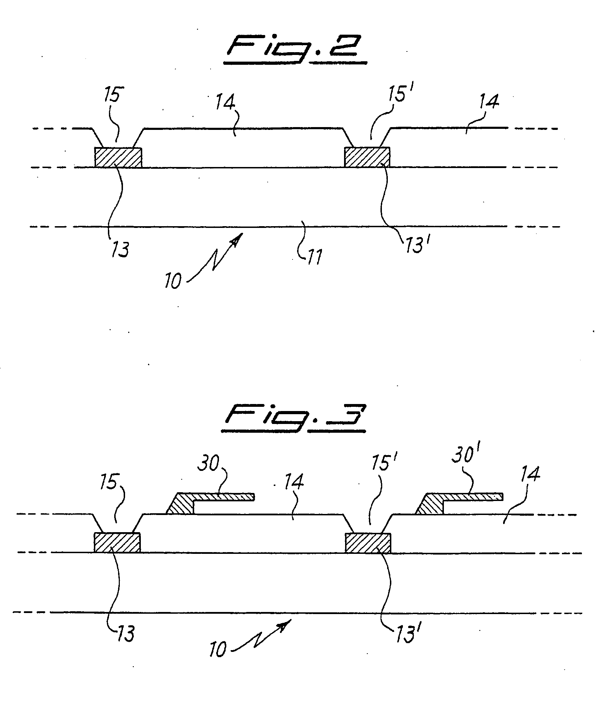

As also shown in Fig. 2, in layer 14, in correspondence of deposits 13, 13',..., are then realized passages 15, 15', ..., having function of exposing the gas absorbing material to the atmosphere surrounding support 10. Passages 15, 15', ..., can be made by selective removal of layer 14 upon deposits 13, 13', ..., through removing techniques know in the art.

The gas absorbing material utilized for deposits 13, 13', ... can be any material free from the phenomenon of lost particles, chosen among materials commonly called getter, capable of absorbing various gas molecules, and drier materials, specific for the absorption of water vapor.

In case of a getter material, it can be a metal such as Zr, Ti, Nb, Ta, V; an alloy among these metals or among these and one or more elements, chosen among Cr, Mn, Fe, Co, Ni, Al, Y, La and rare-earths, like binary alloys Ti-V, Zr-V, Zr-Fe and Zr-Ni, ternary alloys Zr-Mn-Fe or Zr-V-Fe, or alloys with more components. For this application, preferred getter materials are titanium, zirconium, the alloy of weight percentage composition Zr 84%-Al 16%, produced and sold from applicant with name St 101^{®}, the alloy of weight percentage composition Zr 70%-V 24.6%-Fe 5.4%, produced and sold from applicant with name St 707^{®} and the alloy of weight percentage composition Zr 80.8%-Co 14.2%-TR 5% (wherein TR is a rare-earth, yttrium, lanthanum or mixtures thereof), produced and sold from applicant with name St 787; in case the getter material is not completely free from the lost particles phenomenon, it can be properly treated so to reduce or eliminate said phenomenon, for example through a partial sintering or annealing treatment.

In case of drier materials, these are preferably chosen among the oxides of alkali or alkaline-earth metals; particularly preferred is the use of calcium oxide, CaO, that does not pose safety or environmental problems during production, use or disposal of devices containing it. An oxide layer may be obtained for instance through the so-called "reactive sputtering" technique, depositing the alkali or alkaline-earth metal of interest under an atmosphere of a rare gas (generally argon) in which a low percentage of oxygen is present, so that the metal is converted to its oxide during deposition. These layers are generally compact and free from the problem of lost particles.

Deposits 13, 13', ..., can be obtained through known techniques of selective deposition, and have thickness in the range between about 0,1 and 5 µm: with thickness values lower than the indicated ones, gas sorption capability is excessively reduced, while with higher thickness values deposition times are extended without any real advantages on sorption properties. Said deposits have lateral dimensions variable within wide ranges depending on final destination device: for example, if utilization is expected in ICs, lateral dimension will be within the range of some micron or less, while in the case of MMs, dimensions can be included between a few tens and a few hundreds micron.

Material constituting layer 14 is one of the materials normally used as substate in solid state devices production; it can be a so-called III-V material (for example, GaAs o InP), or preferably silicon. Layer 14 can be obtained by sputtering, epitaxy, CVD or by others techniques known in the field. It has a variable thickness, which is generally lower than 60 µm in areas free from deposits 13, 13', ..., and preferably within the range of about 1-20 µm.

To help adhesion, layer 14 is preferably realized with the same material as base 11; preferred combination is silicon (mono- or polycrystalline) for base 11, and silicon grown by epitaxy for layer 14.

Upper surface of layer 14 can also be treated thus modifying its chemical composition, for example forming an oxide or a nitride, in view of the following operations of devices production.

Supports can be therefore utilized in the production of solid state devices of every kind. As appears from previous description, in supports completed and ready for utilization or commercialization, deposits of gas absorbing material are "uncovered", that is, exposed to external atmosphere. To avoid the risk of excessive passivation and damaging of the absorbing material, it is then preferable to keep supports inside boxes under inert atmosphere, for instance argon or dry nitrogen, as known in the art.

Figs. 3-5 show a possible use of support 10 in solid state devices production, particularly referring to micromachines production. However, the same support could be utilized for manufacturing other solid state devices.

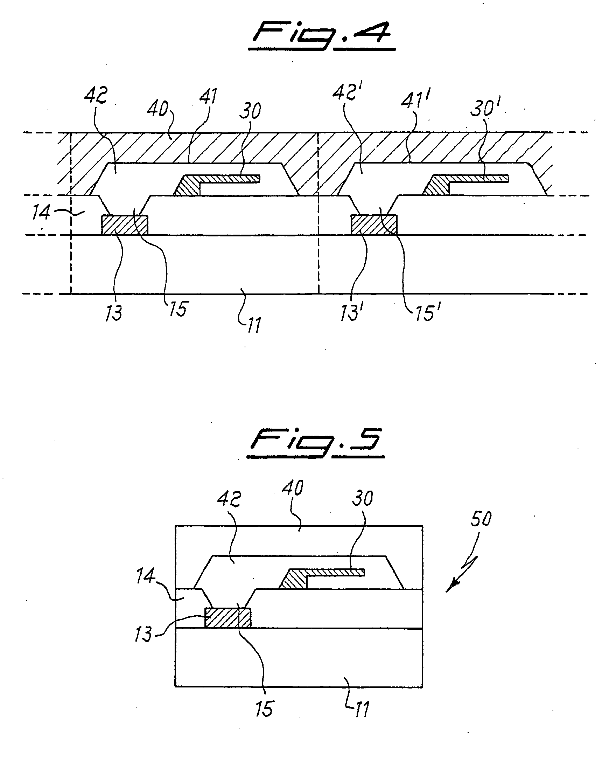

Upon areas of surface of layer 14 without passages 15, 15', ..., are manufactured structures comprising micromachine mobile parts, schematized as elements 30, 30', ... in Fig. 3. When structures 30, 30', ...production (including contacts for outside electric connection of every single micromachine, not shown in the drawing) is finished, a covering element 40 is placed over support 10, as shown in section in Fig. 4. Said covering element is generally realized with the same base 11 materials and it has to be easily fixable to layer 14 (silicon utilization is preferred). Covering element 40 can have holes, 41, 41', ..., in correspondence with areas wherein, on support 10, structures 30, 30', ..., arc obtained and deposits 13, 13', ..., of gas absorbing material are exposed. In particular each of said holes will be so wide that, when support 10 and covering element 40 are fixed together, a space 42, 42', ..., is obtained wherein a structure like 30, 30', ..., and a passage 15, 15', ..., giving access to the gas absorbing material, are contained, so that this latter is in direct contact with space 42, 42', ..., and is able to sorb gas possibly present or released during time in said space. Finally, single micromachines, as the one represented in Fig. 5, are obtained by cutting the whole made up of support 10 and covering element 40 along their adhesion areas.

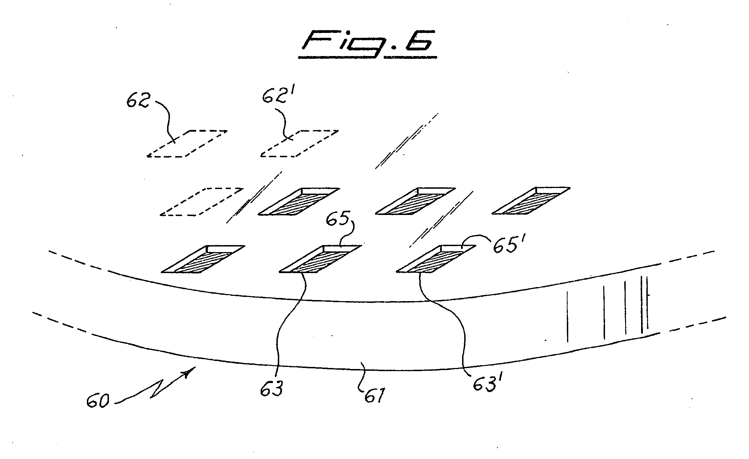

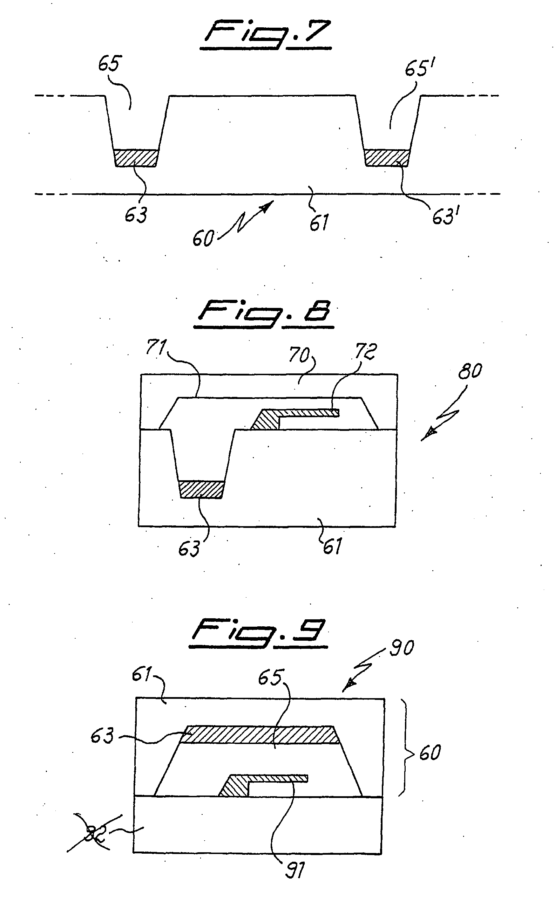

Figs. 6 and 7 show, partially in section, a support of the invention. Also in this case a support 60 comprises a base 61 of the same kind and dimensions of base 11 previously described, but in which are obtained hollows 65, 65', ..., localized in areas 62, 62', ..., and fitted to contain gas absorbing material deposits 63, 63', .... Thanks to its peculiar hollows conformation, base 61, can substitute the assembly made up of base 11 and layer 14.

Fig. 8 represents a solid state device 80, in particular a micromachine, which can be obtained from support 60 of Figs. 6 and 7, through a process similar to the one described with reference to Figs. 3-5 and utilizing a covering element 70 provided with holes 71, ..., in correspondence with areas wherein, on support 60, structures 72, ..., are disposed and gas absorbing material deposits 63, 63', ..., are exposed.

In a variation of the processes defined above, the result of which is micromachine 90 shown in figure 9, support 60 of the invention is utilized as covering element of a solid state device instead of as base of the same. In this case, the base on which micromachine is constructed is a traditional one, without gas absorbing material deposits. Hollow 65, obtained inside base 61, forms thus a space for housing mobile structure 91 and, at the same time, the passage giving access to gas absorbing material.

## Claims

1. A support (60) for manufacturing micromechanical devices, comprising a base (61) having functions of mechanic support, **characterized in that** said base is provided with hollows (65, 65', ...) containing discrete deposits (63, 63', ...) of a gas absorbing material which are at least partially exposed to the atmosphere present nearby said support (60), said hollows (65, 65', ...) forming a space for housing mobile structures (91) of said micromechanical devices.

2. A support according to claim 1 **characterized in that** material with which said base (61) is realized is chosen among a metal, a ceramic, a glass or a semiconductor.

3. A support according to claim 2, **characterized in that** said material is silicon.

4. A support according to claim 1 **characterized in that** said gas absorbing material is a getter material.

5. A support according to claim 4 wherein said getter material is chosen among the metals Zr, Ti, Nb, Ta, V, alloys among these metals or alloys among these metals and one or more elements chosen among Cr, Mn, Fe, Co, Ni, Al, Y, La and rare-earths.

6. A support according to claim 5 **characterized in that** said getter material is titanium.

7. A support according to claim 5 **characterized in that** said getter material is zirconium.

8. A support according to claim 5 **characterized in that** said getter material is an alloy having a weight percentage composition Zr 84%-A1 16%.

9. A support according to claim 5 **characterized in that** said getter material is an alloy having a weight percentage composition Zr 70%-V 24.6%-Fe 5.4%.

10. A support according to claim 5 **characterized in that** said getter material is an alloy having a weight percentage composition Zr 80.8%-Co 14.2%-TR 5%, wherein TR means a rare earth, yttrium, lanthanum or their mixtures.

11. A support according to claim 1, **characterized in that** said gas absorbing material is a drier material.

12. A support according to claim 11 **characterized in that** said drier material is chosen among the oxides of alkali or alkaline-earth metals.

13. A support according to claim 12 **characterized in that** said drier material is calcium oxide.

14. A support according to claim 1, **characterized in that** said discrete deposits (63, 63', ...) of gas absorbing material have a thickness within the range 0,1-5 µm.

15. Use of a support of claim 1 as covering element in the production of a micromechanical device.

## Patentansprüche

1. Träger (60) zum Herstellen von mikromechanischen Vorrichtungen, umfassend eine Basis (61), die als mechanischer Träger fungiert, **dadurch gekennzeichnet, dass** dieser Basisausnehmungen (65, 65',...) aufweist, die einzelne Ablagerungen (63, 63',...) eines gasabsorbierenden Materials enthält, welche zumindest teilweise mit der Atmosphäre, die nahe bei dem Träger (60) vorliegt in Kontakt steht, wobei die Ausnehmungen (65, 65',...) Raum für mobile Strukturen (91) der mikromechanischen Vorrichtungen bieten.

2. Träger nach Anspruch 1, **dadurch gekennzeichnet, dass** das Material, mit dem die Basis (61) hergestellt wurde, ausgewählt ist aus Metall, Keramik, Glas oder einem Halbleiter.

3. Träger nach Anspruch 2, **dadurch gekennzeichnet, dass** das Material Silikon ist.

4. Träger nach Anspruch 1, **dadurch gekennzeichnet, dass** das gasabsorbierende Material ein Gettermaterial ist.

5. Träger nach Anspruch 4, wobei das Gettermaterial ausgewählt ist aus den Metallen Zr, Ti, Nb, Ta, V, Legierungen aus diesen Metallen oder Legierungen aus diesen Metallen und einem oder mehreren Elementen ausgewählt aus Cr, Mn, Fe, Co, Ni, Al, Y, La und Seltenen Erden.

6. Träger nach Anspruch 5, **dadurch gekennzeichnet, dass** das Gettermaterial Titan ist.

7. Träger nach Anspruch 5, **dadurch gekennzeichnet, dass** das Gettermaterial Zirkon ist.

8. Träger nach Anspruch 5, **dadurch gekennzeichnet, dass** das Gettermaterial eine Legierung ist, die eine Zusammensetzung in Gew.% von Zr 84%-Al 16% aufweist.

9. Träger nach Anspruch 5, **dadurch gekennzeichnet, dass** das Gettermaterial eine Legierung ist, die eine Zusammensetzung in Gew.% aufweist von Zr 70%-V 24,6%-Fe 5,4%.

10. Träger nach Anspruch 5, **dadurch gekennzeichnet, dass** das Gettermaterial eine Legierung ist, die eine Zusammensetzung in Gew.% von Zr 80,8%-Co 14,2%-TR 5% ist, wobei TR ein seltenen Erdenmetall, Yttrium, Lanthan oder Gemische hiervon bedeutet.

11. Träger nach Anspruch 1, **dadurch gekennzeichnet, dass** das gasabsorbierende Material ein Trocknungsmittel ist.

12. Träger nach Anspruch 1, **dadurch gekennzeichnet, dass** das Trocknungsmittel ausgewählt ist aus Oxiden von Alkali- oder Erdalkalimetallen.

13. Träger nach Anspruch 12, **dadurch gekennzeichnet, dass** das Trocknungsmittel Calciumoxid ist.

14. Träger nach Anspruch 1, **dadurch gekennzeichnet, dass** die einzelnen Abscheidungen (63, 63',...) von gasabsorbierendem Material eine dicke innerhalb des Bereichs von 0,1-5 µm aufweisen.

15. Verwendung eines Trägers nach Anspruch 1 als Verpackungsmittel bei der Herstellung von einer mikromechanischen Vorrichtung.

## Revendications

1. Support (60) pour fabriquer des dispositifs micromécaniques, comprenant une base (61) ayant des fonctions de support mécanique, **caractérisé en ce que** ladite base est munie de creux (65, 65', ...) contenant des dépôts discrets (63, 63', ...) d'un matériau d'absorption de gaz qui sont au moins partiellement exposés à l'atmosphère présente près dudit support (60), lesdits creux (65, 65', ...) formant un espace pour recevoir des structures mobiles (91) desdits dispositifs micromécaniques.

2. Support selon la revendication 1, **caractérisé en ce que** le matériau, avec lequel ladite base (61) est réalisée, est choisi parmi du métal, des matières céramiques, du verre ou un semi-conducteur.

3. Support selon la revendication 2, **caractérisé en ce que** ledit matériau est du silicium.

4. Support selon la revendication 1, **caractérisé en ce que** ledit matériau d'absorption de gaz est un matériau de getter.

5. Support selon la revendication 4, dans lequel ledit matériau est choisi parmi les métaux Zr, Ti, Nb, Ta, V, des alliages parmi ces métaux ou des alliages parmi ces métaux et un ou plusieurs éléments choisis parmi Cr, Mn, Fe, Co, Ni, Al, Y, La et des lanthanides.

6. Support selon la revendication 5, **caractérisé en ce que** ledit matériau de getter est du titane.

7. Support selon la revendication 5, **caractérisé en ce que** ledit matériau de getter est du zirconium.

8. Support selon la revendication 5, **caractérisé en ce que** ledit matériau de getter est un alliage ayant une composition, en pourcentage en poids, de 84 % de Zr - 16 % de Al.

9. Support selon la revendication 5, **caractérisé en ce que** ledit matériau de getter est un alliage ayant une composition, en pourcentage en poids, de 70 % de Zr - 24,6 % de V - 5,4 % de Fe.

10. Support selon la revendication 5, **caractérisé en ce que** ledit matériau de getter est un alliage ayant une composition, en pourcentage en poids, de 80,8 % de Zr - 14,2 % de Co - 5 % de TR, dans laquelle TR signifie un lanthanide, de l'yttrium, du lanthane ou leurs mélanges.

11. Support selon la revendication 1, **caractérisé en ce que** ledit matériau d'absorption de gaz est un matériau de séchage.

12. Support selon la revendication 11, **caractérisé en ce que** ledit matériau de séchage est choisi parmi les oxydes de métaux alcalins ou alcalino-terreux.

13. Support selon la revendication 12, **caractérisé en ce que** ledit matériau de séchage est de l'oxyde de calcium.

14. Support selon la revendication 1, **caractérisé en ce que** lesdits dépôts discrets (63, 63', ...) de matériau d'absorption de gaz ont une épaisseur dans la plage de 0,1 à 5 µm.

15. Utilisation d'un support selon la revendication 1, en tant qu'élément de recouvrement dans la production d'un dispositif micromécanique.
